(19) Europäisches Patentamt
European Patent Office
Office européen des brevets

(11) **EP 0 411 692 B1**

(12) **EUROPEAN PATENT SPECIFICATION**

(45) Date of publication and mention
of the grant of the patent:
**28.10.1998 Bulletin 1998/44**

(51) Int Cl.⁶: **H03M 7/40**, G06F 7/00,
H03M 7/30, G06F 19/00

(21) Application number: **90201996.7**

(22) Date of filing: **23.07.1990**

(54) **Lempel-Ziv decoder**

Lempel-Ziv-Dekodierer

Decodeur de Lempel-Ziv

(84) Designated Contracting States:
**DE FR GB IT NL**

(30) Priority: **31.07.1989 US 388282**
**31.07.1989 US 388283**
**31.07.1989 US 388281**

(43) Date of publication of application:
**06.02.1991 Bulletin 1991/06**

(73) Proprietor: **Koninklijke Philips Electronics N.V.**
**5621 BA Eindhoven (NL)**

(72) Inventors:
• **Shah, Imran**
**NL-5656 AA Eindhoven (NL)**
• **Johnson, Brian**
**NL-5656 AA Eindhoven (NL)**

(74) Representative: **Peters, Rudolf Johannes et al**
**INTERNATIONAAL OCTROOIBUREAU B.V.,**
**Prof. Holstlaan 6**
**5656 AA Eindhoven (NL)**

(56) References cited:
• **COMPUTER vol. 17, no. 6 , June 1984 , LONG BEACH US pages 8 - 19 WELCH 'a technique for high-performance data compression'**
• **IEEE SOFTWARE vol. 5, no. 4 , July 1988 , LOS ALAMITOS US pages XTEN77 - 85 KELLEY ET AL 'multikey,extensible hashing for relational databases'**
• **1990 IEEE INTERNATIONAL SYMPOSIUM ON CIRCUITS AND SYSTEMS vol. 1 , May 1990 , NEW YORK (US) pages 41 - 44 SHAH ET AL 'data compressor decompressor ic'**

**Description**

The invention relates to a decoder for Lempel-Ziv encoded data, comprising:

memory means for storing code words and data corresponding to the stored code words;
receiving means for receiving and storing a code word to be decoded;
storing means for storing data elements read out from said memory means during decoding; and
applying means for applying said code word to be decoded to said memory means for reading out a data element and a prefix coded as another code word, said applying means further supplying said data element to said storing means, applying said another code word to said memory means for reading out a further data element and a successive code word, supplying said further data element to said storing means, and applying each successive code word read out from said memory means to said memory means until the stored code word is decoded.

A good introduction into the Lempel-Ziv (LZ) algorithm can be found in the article by Terry A. Welch, 'A Technique for High-Performance Data Compression', Computer, June 1984, pp. 8-19. The algorithm therein will be summarized below.

In the LZ compressions algorithm, strings of input characters are mapped into fixed-length code words. Data decompression uses the same string table as the data compression step and constructs it as the message is translated. During message translation the characters within each string are generated in reverse order.

A problem of the data decompressing is the high processing power requirement. Accordingly, amongst other things it is an object of the present invention to provide a special-purpose data decoder that can be used in a data processing or transmission system. It is an object to provide means for straightforwardly reversing the translated character string.

Therefore, according to one of its aspects, the invention is characterized by

determining means for determining when the code word is one ot a set ot basic code words indicating the end of a string;
maintaining means for maintaining the address value of the next entry to be made in said memory means;
register means for storing the previously received code word and the first character of the current code word into said memory means and for making a new decoder table entry in response to the determination of the end of the string condition.

A decoder for decoding Lempel-Ziv encoded data comprises a memory in which code words are stored and data words corresponding to the code words. The data are stored in the form of the combination of a data element and a second code word, which second code word represents another combination of a data element and a (third) code word. Decoding occurs by retrieving data elements and code words until all data elements of the original code word are retrieved and the code word is decoded. The retrieved data are subsequently reversed by a last-in first-out memory.

A last-in first-out memory circuit as used comprises first and second memories, and a third memory which operates as an overflow memory. First means and second means each develop a respective sequence of memory address signals. The sequence of memory address signals from said first means is applied to the first memory, and the sequence of memory address signals from said second means is applied to the second memory. An address signal multiplexer receives the two sequence of memory address signals and applies one or the other to the third memory.

The other circuit elements are controlled by control means to achieve the desired mode of operation. An input data string is applied, for example, to the first memory and stored at a sequence of addresses determined by the sequence of memory address signals from said first means. In the event the input string length exceeds the capacity of the first memory the address signal multiplexer under control of said control means switches the sequence of memory address signals to said third memory and the data string is further stored in said third memory in order at memory locations determined by the sequence of memory address signals from said first means.

After the input string has been stored a subsequent input string is stored in said second memory in the same manner. A sequence of memory address signals from said second means is applied to said second memory, and the input string is stored in said second memory in sequence.

During the same time that the input string is being stored in said memory the string previously stored in said first memory is read out. Said first means develops a sequence of memory address signals to read out the string stored in the first memory (and, in this example, in the third memory). The sequence of memory address signals is developed by said second means in reverse order from that in which it was developed during storage of the string. In this way, the stored string is read out in reverse order, i.e., on a last-in first-out basis.

The decoding can be readily implemented with a pipeline architecture which eliminates any penalty in system throughput arising from two access of the hash memory and the memory for the associated key and other data. This is achieved by the use of a register or other store between the first and second memories. This architecture allows a

EP 0 411 692 B1

key to be hashed to an address in the first memory block and the stored pointer value to be read out and stored in the pipeline register. The pointer value in the register is subsequently used to read out the associated key data from the second memory block. During the time interval that the second memory block is being accessed, a subsequent key can be hashed to the first memory block, and consequently the hashing of the subsequent key is substantially eliminated from the total search time. As a result, throughput is as high as if only a single access were required.

BRIEF DESCRIPTION OF THE DRAWING

Fig. 1 illustrates the data organization used in the present invention;
Fig. 2 illustrates a memory architecture used with this data structure;
Fig. 3 illustrates an extended memory architecture used with this data structure;
Fig. 4 illustrates a data compressor-decompressor having the memory architecture shown in Fig. 3;

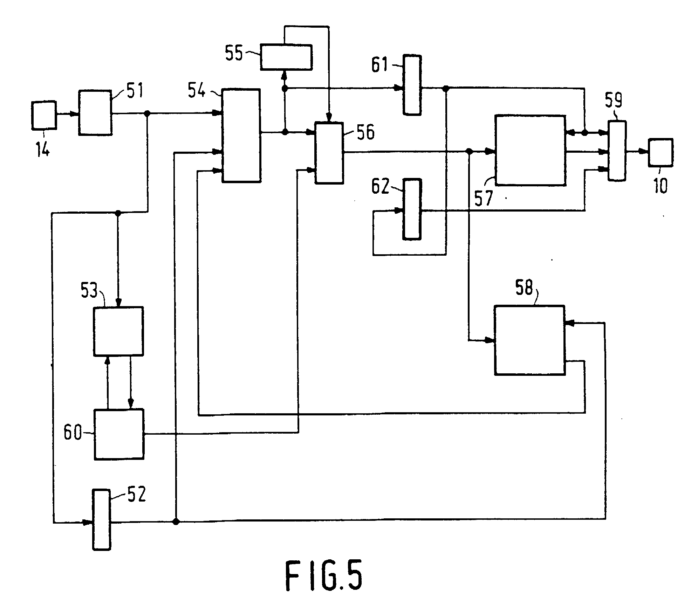

Fig. 5 illustrates a decoder used in the compressor-decompressor shown in Fig. 4.

DETAILED DESCRIPTION OF THE INVENTION

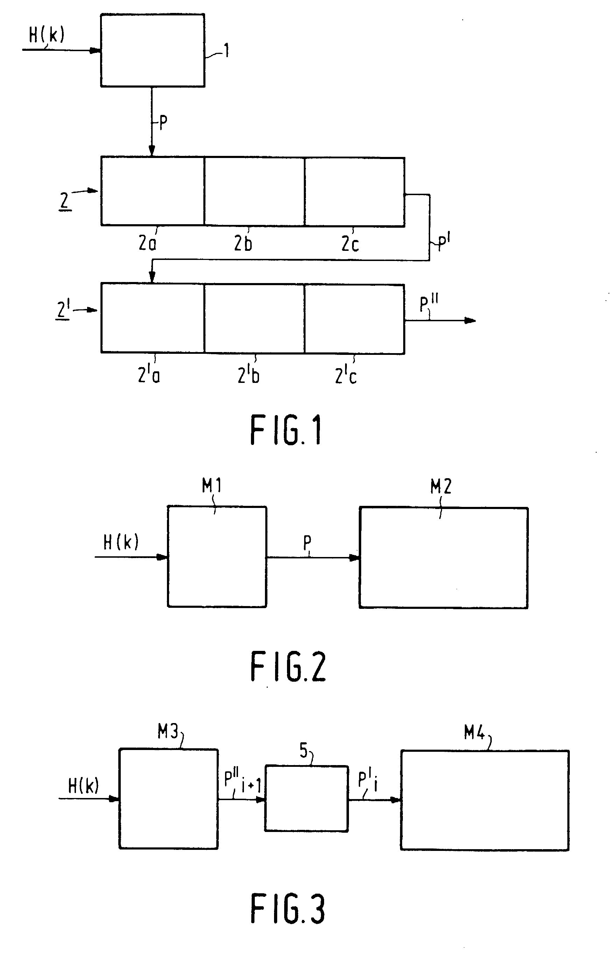

The data organization is illustrated in Fig. 1. A link field is stored in a memory location 1 independently of other data at an address corresponding to a hash function value H(k). Multiple link fields are stored in memory in a table at addresses corresponding to hash table values, and the value stored in the link field 1 at a hash table address is a pointer P to the memory location 2a or address of a corresponding key and any other associated data fields 2b. Each key is contained in a record 2 which also has an associated link field 2c for storing a pointer P' to a record 2' of a successive key corresponding to the same hash address, with key field 2'a, data field 2'b and link field 2'c.

The corresponding memory architecture in Fig. 2 comprises a first memory M1 and a second memory M2. The first memory M1 stores only the link field values at the addresses comprising the hash table. Each address of the memory Ml is a hash table address and is addressed by a hash function value H(k) applied to the memory M1. The capacity of memory M1 is chosen to optimize hashing according to a desired criteria. A predetermined load factor of the memory M1 can be achieved through selecting the capacity of memory M1.

The capacity of memory M1 and its load factor can be selected according to the size of the hash table. There is no need to consider the number of key fields or other data fields that will be stored, in order to select the capacity of memory M1. Memory M2 is used to store the key, other associated data fields, and an associated link field for a pointer to a record of a successive key.

Data stored in memory M2 can be inserted successively, and the address values at which the keys and other data are stored are the pointer values in the memory M1. The capacity of memory M2 is selected to be sufficient to meet the storage requirements for the keys and other associated data. The link fields in memory M2 permit to use chaining for collision resolution. The first key corresponding to a particular hash address that is inserted in the memory M2 has an address in memory M2 corresponding to the pointer stored in memory M1 at the hash address H(k). The second key corresponding to the same hash address H(k) is stored in memory M2 at an address of memory M2 which is stored in the link field of the record containing the first key. In this way, a linked list is created within memory M2 that is accessed through the pointer value stored in memory M1. The keys and other data successively stored in memory M2 can be stored in contiguous memory in the form of linked lists to maximize utilization of memory M2. The records associated with all keys for the same hash address need not to be stored contiguously in the memory M2.

The decoupling of the hash addresses and the associated key and other associated data fields necessitates a minimum of two memory accesses in order to retrieve a key. If the stored data must be accessed repeatedly it would be desirable to eliminiate, or at least greatly reduce, the increased access time of the memory architecture.

Fig. 3 illustrates another memory embodiment comprised of a first memory M3 for storing the link fields comprising the hash table. A second memory M4 stores key and other associated data fields, and link fields associated with each key. Thus, both embodiments use the same method of data organization. This second embodiment further comprises a register 5 for storing the pointer values read out from the first memory M3, and for using the pointer values stored therein to access the second memory M4. The storage of the pointer value P read out from the first memory M3 within the register 5 permits a second key to be hashed to the first memory M3 while the second memory M4 is being accessed.

For example, suppose a key $k_i$ is hashed to a particular address in the first memory M3 and a pointer $P_i$ stored at that address is read out. At the next read operation a subsequent key $k_{i+1}$ will be hashed to another address of the memory M3 containing a pointer $P_{i+1}$, while the pointer value $P_i$ in the register 5 will address the memory M4 to read out the data associated with $k_i$. The system can look for a match of key $k_i$ with the content of memory M4 while the key $k_{i+1}$ is being hashed to the first memory M3. If a match with key $k_i$ is attained the pointer $P_{i+1}$ associated with key $k_{i+1}$ can be applied to the second memory M4; otherwise, nothing is done with the pointer corresponding to key $k_{i+1}$ until key $k_i$ is resolved as either a success or failure. In either event, the access of the first memory M3 by the hashed value of key $k_{i+1}$ will have already occurred and will not contribute to the total search time.

3

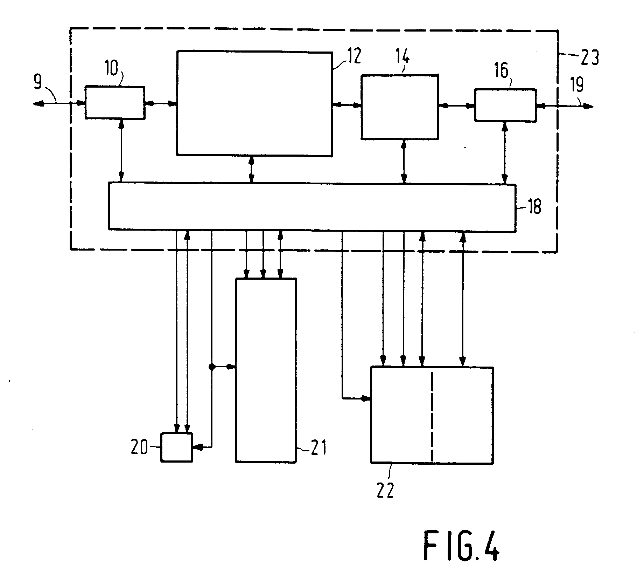

One application for the disclosed data structure and memory architecture is in the area of data compression, for example of a digitalized image. Fig. 4 illustrates the structure of a dedicated integrated circuit for carrying out data compression according to the Lempel-Ziv algorithm, in which hashing is carried out by hardware circuits. The data which is hashed is organized and stored in a memory as just described.

The LZ algorithm parses a message comprised of a sequence of characters character-serially in one pass, and the longest recognized input string S is parsed off each time. A recognized string is one that already exists in the string table. The code word for the recognized string S is transmitted, and the recognized string S with the next character C of the message appended, SC, is added to the string table and assigned a unique code word.

The LZ algorithm can be more explicitly described as follows:

```
Initialize string table to contain single-character
        strings of message characters
Read first input character --- > prefix string S
STEP: Read next input character C
        If no such C (input exhausted): code S --> output; EXIT
        If SC exists in string table: SC --- > S; repeat STEP
        Else SC not in string table: code (S) --- > output
                SC ---> string table
                C ---> S; repeat STEP
```

Starting with an initialized string table containing the character set from which the message will be composed, the first message character is read and set to the prefix string S. If there is a subsequent message character it is read and appended to the prefix string to form the new string SC. The string table is then checked to determine whether the string SC is already entered. If there already is an entry for SC, then the string SC is set to the prefix string S, the next message character C is read, and the step is repeated. Otherwise, if the string SC is not in the table, the output code word for the prefix string S is transmitted, a new table entry for the string SC is created, the character C is set to the prefix string S, and the step is repeated.

The data compressor/decompressor shown in Fig. 4 has a first-in first-out buffer memory (FIFO) 10 having an input which constitutes a data port 9 which receives the sequence of message characters to be compressed. FIFO 10 is used to smooth the data rate which could otherwise vary because of the variable search times that can occur during exection of the LZ algorithm.

A coder/decoder (CODEC) 12 receives the output from the FIFO 10 and encodes the applied signal according to the LZ algorithm by operating in the encoding mode. The encoded signals from the CODEC 12 are applied to repacker (REPAC) 14 which accepts input data streams of variable width and which generates output data streams of variable width. The repacker 14 output is applied to the FIFO 16 which is effective to smooth the rate of the code signals sent from the code port 19 of the data compressor/decompressor.

The FIFO's 10 and 16, the CODEC 12 and the repacker (REPAC) 14 are initialized and put in operation by the microprocessor/ memory interface 18. The interface 18 receives control signals from the system in which the data compressor/ decompressor is incorporated, and passes signals between the components of the data compressor/ decompressor just described and memories used by it. The FIFO's 10 and 16, CODEC 12, repacker (REPAC) 14 and interface 18 are, in the preferred embodiment, fabricated as a single integrated circuit 23, as shown by the dashed line in Fig. 4. The memories 20, 21 and 22, which are described below, are separate components. Alternatively, some or all of the components of the data compressor/decompressor could be constructed as separate units, or memory could be provided on the integrated circuit comprising the data compressor/ decompressor.

The memory architecture requires that the Lempel-Ziv algorithm be executed somewhat differently than the basic LZ algorithm described above. This is because the first memory 21 contains only pointer values and thus can not be addressed without the string prefix, and the string prefix will not be available without accessing and resolving the search in the second memory 22.

In order to use the pipelined memory architecture the LZ algorithm is executed by assuming a prefix and then hashing the prefix-data combination. If the resulting pointer value is stored in the first memory 21 a success is assumed. Accordingly, a successive assumed prefix and new data are hashed to the first memory 21 while the key derived from the previous hashing operation addresses the second memory 22. If there is a match between the two keys one cycle of the processing of the next-prefix data will have been achieved. On the other hand, if the key does not match, i.e. there is a failure, the assumption about the prefix was incorrect. In the next cycle the key will be written in the second memory, and also during that cycle the new key with the corrected prefix will be hashed to the first memory. In this way the speed increase attributable to a pipeline architecture can be achieved with the LZ algorithm.

The justification of anticipating the prefix value is a consequence of the fact that the LZ algorithm compresses data such as an image by a factor of two to three, with average string lengths of between four and six data elements. This results in success about three times more frequently than failure when searching for a prefix-data combination. Consequently, one can anticipate a prefix and be correct 75% of the time, even before a prefix can actually be resolved.

The CODEC 12 includes circuitry for both encoding input data according to the LZ algorithm, and for decoding LZ-encoded data.

The decoder circuit of the CODEC 12 is shown in Fig. 6. Current code word register 51 receives a code word from the repacker 14. The register 51 receives a code word after a previous code word has been decoded so that the code word stored in the register 51 is the current code word to be decoded. The code word stored in the register 51 is also stored in the register 52 for use as the previous code word after the register 51 receives a new code word. Finally, the current code word is tested by the circuit 53 to determine whether it is "Special" as described later.

The multiplexer 54 applies the current code word to the comparator 55 which checks whether the code word belongs to the "Basic" set or is a "Special" case. If the code word is not Basic and not Special the multiplexer 56 passes it to be used as an address for retrieving the data-code word entry at that address in the data memory 57 and code word memory 58. The data at that address is transmitted through the multiplexer 59 to the LIFO 10. Similarly, the code word retrieved from that address in code word memory 58 is used again, and is transmitted through multiplexer 54 to the comparator 55 to determine whether it is Basic. This sequence of steps is repeated until the code word retrieved from the code word memory 58 is Basic.

If the code word is determined to the Basic, the end-of-string condition has been reached. The end-of-string condition occurs when the decoder has completed unraveling the string represented by the current code word. At this time the decoder is ready to make a new entry in the decoder table at the memory address pointed to by the next-entry counter 60 through the multiplexer 56. The decoder is also ready to accept a new code word from the current-code-word register 51. In the next cycle of operation the Basic code word is output from the register 61 through the multiplexer 59. At the same time a new entry comprising the previously received code word stored in the register 52 is written into the code word memory 58, and the first character of the current code word, stored in register 61, is written in data memory 57. A new code word is also taken from the current code word register 51 at this time.

A code word is considered Special if it is also the next entry to be made in the decoder table. The new code word is compared by the Special comparator 53 with the count value of the next entry counter 60. If the new code word and the next entry counter value match, the code word is Special. Because no entry corresponding to this code word has been made in the decoder tables, the data memory 57 and the code word memory 58 will not be accessed in the following cycle of operation. Instead, the first character of the previous code word, stored in the register 62 is transmitted to the LIFO 10 through the multiplexer 59. To continue the decoding the previously received code word from the register 52 is passed through the multiplexer 54 and used as the address to access the data memory 57 and the code word memory 58.

The scheme for generating the hash function is implemented by a special purpose circuit. Before describing the hash function generating circuit the mathematical functions governing the hash function will be considered.

The design of hash function generators has received considerable attention. The hash function generator must efficiently generate the hash function from the key, and it must perform a pseudo-randomizing function so that all of the keys are not mapped into the same hash address.

For example, a small five-character ASCII field would require $(128)^5$ or over one trillion memory addresses, if it were to be stored in unique addresses corresponding to its value. The first character of the five character field might be taken as a simple hash function thereby reducing the address field of the hash function to only 128 locations. To retrieve a data item of interest one would address the memory location corresponding to the value of the first character of the key, and then look for the entry with the key that matches all five characters. Obviously, if every key started with the same character, then the desired key and data could be retrieved only by searching the entire address space of the keys.

It should also be noted that in the given example, all keys corresponding to a particular hash function have the same first character. Thus, in such a case the first character of the keys need not be stored, and an abbreviated key can be used instead. In this example the abbreviated key would be the last four letters of the word. Accordingly, it would be desirable to use a hash function generator that is efficient, is pseudo-randomizing and which permits the use of abbreviated keys. This last property imposes the requirement that the hash function and the abbreviated key uniquely represent the input key.

According to the method that is employed, the key k, hash function h and abbreviated key a, are represented in binary form as vectors. The hash function generator H and abbreviated key generator A are matrices of 1's and 0's which satisfy the following equations,

$$h = Hk \tag{1},$$

$$a = Ak \tag{2},$$

Equations (1) and (2) can be combined in the following manner

$$\begin{vmatrix} h \\ a \end{vmatrix} = \begin{vmatrix} H \\ A \end{vmatrix} k \quad (3),$$

here

$$\begin{vmatrix} h \\ a \end{vmatrix}$$

is a vector, and

$$\begin{vmatrix} H \\ A \end{vmatrix}$$

is a matrix. If the matrix

$$\begin{vmatrix} H \\ A \end{vmatrix}$$

is invertible, then the following relation holds

$$k = \begin{vmatrix} H \\ A \end{vmatrix}^{-1} \begin{vmatrix} h \\ a \end{vmatrix} \quad (4).$$

Consequently, the combination of the hash function h and the abbreviated key a uniquely represent the original key k. This is an important feature. The uniqueness of the combination of the hash function and the abbreviated key allows for the storage of just the abbreviated key in the second memory with an attendant reduction in memory requirements, and without the loss of the ability to resolve collisions.

The form of the hash function generator H, and the operations required to compute equation (1), are particularly well suited to hardware implementation. This can be seen by expanding equation (1) to show the individual elements of the matrix H and vector k as follows:

$$h = \begin{vmatrix} h_{11} & h_{12} & \dots & h_{1n} \\ h_{21} & & & \cdot \\ \cdot & & & \cdot \\ \cdot & & & \cdot \\ h_{m1} & h_{m2} & & h_{mn} \end{vmatrix} \begin{vmatrix} k_1 \\ \cdot \\ \cdot \\ \cdot \\ k_n \end{vmatrix} \qquad (5).$$

The hash function generator H is an m x n matrix, where $h_{ij} = 0$ or 1. The key k is a column vector of n bits, and $k_i = 0$ or 1. Carrying out the matrix multiplication yields:

$$h = \begin{vmatrix} h_{11} \ k_1 \ + \ h_{12} \ k_{12} \ + \ \dots \ + \ h_{1n} \ k_n \\ \cdot \\ \cdot \\ h_{21} \ k_1 \\ \cdot \\ \cdot \\ h_{m1} \ k_1 \ + \ h_{m2} \ k_2 \ + \ \dots \ + \ h_{mn} \ k_n \end{vmatrix} \qquad (6)$$

which is an m x 1 column vector. Each element of the hash function h is calculated as the sum

$$h_i = \Sigma \ h_{ij} \ k_j, \ j = 1 \qquad (7),$$

where the multiplications are binary multiplications, or logical AND, and the summation is binary addition without carry, or modulo-two addition. Thus, the products $h_{ij} \ k_j = 1$ or 0 depending upon whether $h_{ij}$ is 1 or 0, and signals corresponding to the products $h_{ij} \ k_j$ can be obtained by simply transmitting or not transmitting the bit $k_j$ depending upon whether $h_{ij}$ is 1 or zero. The ith bit, $h_i$, of the hash function h is then equal to the modulo-two sum of the transmitted $k_j$ values for that particular value of i.

For example, the following hash function generator may be used:

$$H = \begin{vmatrix} 1 & 0 & 1 & 0 & 0 & 1 \\ 0 & 1 & 1 & 0 & 1 & 0 \\ 1 & 0 & 0 & 0 & 1 & 1 \end{vmatrix}$$

which is a (3 x 6) matrix for generating a three-bit hash function from a six-bit key.

## Claims

1. A decoder for decoding Lempel-Ziv encoded data, comprising:

   memory means (57, 58) for storing code words and data corresponding to the stored code words;
   receiving means (51) for receiving and storing a code word to be decoded;
   storing means (10) for storing data elements read out from said memory means during decoding; and
   applying means (54, 56) for applying said code word to be decoded to said memory means for reading out a data element and a prefix coded as another code word said applying means further supplying said data element to said storing means, applying said another code word to said memory means for reading out a further data element and a successive code word, supplying said further data element to said storing means, and applying each successive code word read out from said memory means to said memory means until the stored code word is decoded,

characterized by

determing means (55) for determining when the code word is one of a set of basic code words indicating the end of a string;
maintaining means for (53, 60) for maintaining the address value of the next entry to be made in said memory means;
register means (52) for storing the previously received code word and the first character of the current code word into said memory means and for making a new decoder table entry in response to the determination of the end of the string condition.

2. A decoder according to Claim 1, wherein said determining means is a comparator (55) connected to receive the output of said applying means.

3. A decoder according to Claim 1, wherein said maintaining means is a counter (60).

4. A decoder according to Claim 1, wherein said applying means is comprised of a first multiplixer (54) having a first input for receiving the stored code word to be decoded and having a second input for receiving the code word read out from said memory means, and a second multiplexer (56) having a first input for receiving the output of said first multiplexer and a second input for receiving the address value of the next entry to be made in said memory means.

**Patentansprüche**

1. Dekodierer für Lempel-Ziv-kodierte Daten, bestehend aus:

Speichermitteln (57, 58) zum Abspeichern von Kodewörtern und den abgespeicherten Kodewörtern entsprechenden Daten;
Empfangsmitteln (51) zum Empfangen und Abspeichern eines zu dekodierenden Kodeworts;
Abspeicherungsmitteln (10) zum Abspeichern von Datenelementen, gelesen aus den besagten Speichermitteln während dem Dekodieren; und
Anwendungsmitteln (54, 56) zum Anwenden des besagten zu dekodierenden Kodeworts auf die besagten Speichermittel zum Lesen eines Datenelements und eines als anderes Kodewort kodierten Präfixes, die besagten Anwendungsmittel geben zudem das besagte Datenelement an die besagten Abspeicherungsmittel aus, wenden das besagte andere Kodewort auf die besagten Speichermittel an, um ein weiteres Datenelement und ein darauffolgendes Kodewort zu lesen, geben das besagte weitere Datenelement an die besagten Abspeicherungsmittel aus, und wenden jedes darauffolgende, aus den besagten Speichermitteln gelesenes Kodewort auf die besagten Speichermittel an, bis das abgespeicherte Kodewort dekodiert ist,

gekennzeichnet durch

Bestimmungsmittel (55) zum Bestimmen, wenn das Kodewort das eines Satzes von Basiskodewörtern ist, um das Ende einer Zeichenfolge anzuzeigen;
Beibehaltungsmittel (53, 60) zum Beibehalten des Adressenwertes der nächsten in besagte Speichermittel zu machende Eingabe;
Registermittel (52) zum Abspeichern des zuvor erhaltenen Kodeworts und des ersten Schriftzeichens des aktuellen Kodeworts in besagte Speichermittel, und um eine neue Dekodiertabelleneingabe in Antwort auf die Bestimmung des Endes der Zeichenfolgenbedingung zu machen.

2. Dekodierer nach Anspruch 1, in dem die besagten Bestimmungsmittel ein Komparator (55) sind, angeschlossen, um den Ausgang der besagten Anwendungsmittel zu erhalten.

3. Dekodierer nach Anspruch 1, in dem die Besagten Beibehaltungsmittel ein Zähler (60) sind.

**4.** Dekodierer nach Anspruch 1, in dem die besamten Anwendungsmittel aus einem ersten Multiplexer (54) bestehen, mit einem ersten Eingang zum Empfang des abgespeicherten, zu dekodierenden Kodeworts, mit einem zweiten Eingang zum Empfang des aus den besagten Speichermitteln gelesenen Kodeworts, und einem zweiten Multiplexer (56) mit einem ersten Eingang für den Empfang des Ausgangs des ersten Multiplexers und einem zweiten Eingang für den Empfang der Adressenwerte der nächtsten, in die besagten Speichermittel zu machenden Eingabe.

**Revendications**

**1.** Décodeur pour décoder des données encodées Lempel-Ziv, comprenant :

un moyen de mémoire (57, 58) pour mémoriser les mots code et les données correspondant aux mots code mémorisés;
un moyen de réception (51) pour recevoir et mémoriser un mot code devant être décodé;
un moyen de mémorisation (10) pour mémoriser des éléments de données extraits à partir dudit moyen de mémoire durant le décodage,
et un moyen d'application (54, 56) pour appliquer ledit mot code devant être décodé audit moyen de mémoire afin d'extraire un élément de donnée et un préfixe codé en tant qu'autre mot code, lequel moyen d'application fournit en outre ledit élément de donnée audit moyen de mémorisation, applique ledit autre mot code audit moyen de mémoire en vue d'extraire un autre élément de donnée et un mot code successif, fournit ledit autre élément de donnée audit moyen de mémorisation et applique chaque mot code successif extrait à partir dudit moyen de mémoire audit moyen de mémoire jusqu'à ce que le mot code mémorisé soit décodé, caractérisé par un moyen de détermination (55) en vue de déterminer si le mot code est l'un d'un jeu de mots code de base indiquant la fin d'une chaîne;
un moyen de maintien (53, 60) en vue de maintenir la valeur d'adressage de l'entrée suivante devant être effectuée dans ledit moyen de mémoire;
un moyen de registre (52) en vue de mémoriser le mot code reçu précédemment et le premier caractère du mot code courant dans ledit moyen de mémoire et d'effectuer une nouvelle entrée dans le tableau de décodage en réaction à la détermination de la fin de la condition de chaîne.

**2.** Décodeur suivant la revendication 1, dans lequel ledit moyen de détermination est un comparateur (55) connecté afin de recevoir la sortie dudit moyen d' application.

**3.** Décodeur suivant la revendication 1, dans lequel ledit moyen de maintien est un compteur (60).

**4.** Décodeur suivant la revendication 1, dans lequel ledit moyen d'application est constitué d'un premier multiplexeur (54) comprenant une première entrée destinée à recevoir le mot code mémorisé devant être décodé et comprenant une deuxième entrée pour recevoir le mot code extrait dudit moyen de mémoire, et d'un deuxième multiplexeur (56) comprenant une première entrée pour recevoir la sortie dudit premier multiplexeur et une deuxième entrée pour recevoir la valeur d'adressage de l'entrée suivante qui doit être effectuée dans ledit moyen de mémoire.

FIG.1

FIG.2

FIG.3

FIG.4

FIG.5